# EUROPÄISCHE PATENTSCHRIFT

(11) **EP 4 291 338 B1**
(45) Veröffentlichungstag und Bekanntmachung des Hinweises auf die Patenterteilung: **02.04.2025**
(21) Anmeldenummer: 22703347.9
(22) Anmeldetag: 01.02.2022
(51) Int. Cl.: B06B 1/06, G10K 9/122

(54) **VORRICHTUNG UND VERFAHREN ZUR HERSTELLUNG EINER VORRICHTUNG**
DEVICE AND METHOD FOR PRODUCING A DEVICE
DISPOSITIF ET PROCÉDÉ DE FABRICATION D'UN DISPOSITIF

(30) Priorität: 15.02.2021 DE 102021103477
(43) Veröffentlichungstag der Anmeldung: 20.12.2023
(60) Teilanmeldung: 24166934.0
(73) Patentinhaber: TDK Electronics AG, 81671 München (DE)
(72) Erfinder: WALLNÖFER, Wolfgang, 8530 Deutschlandsberg (AT); RAJAPURKAR, Aditya, 8042 Graz (AT); TUREL, Gert, 8572 Bärnbach (AT); MIJOCEVIC, Zdravko, 8530 Deutschlandsberg (AT); PENTSCHER-STANI, Andreas, 8430 Leibnitz (AT)
(74) Vertreter: Epping - Hermann - Fischer
(86) Internationale Anmeldenummer: PCT/EP2022/052338
(87) Internationale Veröffentlichungsnummer: WO 2022/171492

(56) Entgegenhaltungen:
- DE-A1- 102016 116 760
- DE-B3- 102015 015 901
- US-A1- 2008 260 187

## Beschreibung

Die vorliegende Erfindung betrifft eine Vorrichtung zur Schwingungsanregung sowie ein Verfahren zur Herstellung einer derartigen Vorrichtung. Die Vorrichtung ist insbesondere dazu geeignet, ein haptisches Signal zu erzeugen.

Vorrichtungen, bei denen piezoelektrische Elemente an einem Schwingkörper befestigt werden, um ein haptisch wahrnehmbares Signal zu erzeugen, sind beispielsweise aus US 2014/0327839 A1 und aus WO 2000/141264 A1 bekannt. Bei diesen Vorrichtungen kann durch eine elektrische Anregung eines oder mehrerer piezoelektrischer Elemente eine mechanische Resonanzschwingung des Schwingkörpers erzeugt werden. Um einen berührungsempfindlichen Bildschirm mit einer derartigen Vorrichtung ausreichend stark auslenken zu können, sind große, mit zahlreichen piezoelektrischen Elementen besetzte Schwingkörper erforderlich, die bezüglich Platzbedarf, Energieverbrauch und Kosten die Einsatzmöglichkeiten dieser Technik beschränken.

US 2014/0327839 A1 und WO 2000/141264 A1 beschreiben, dass die piezoelektrischen Elemente an dem Schwingkörper durch eine organische Klebeverbindung, beispielsweise auf Epoxid-oder Acrylharzbasis, befestigt sind, wobei die organische Klebeverbindung teilweise Zusätze zur Erhöhung der elektrischen Leitfähigkeit aufweist.

DE 10 2015 015 901 B3 zeigt eine Vorrichtung, die einen Schwingkörper aufweist, auf dem ein piezoelektrisches Element durch eine Lotverbindung befestigt ist. DE 10 2016 116 760 A1 zeigt eine Vorrichtung zur Erzeugung eines haptischen Signals, bei der ein piezoelektrischer Aktuator in einer mechanischen Struktur mit zwei Hebelarmen angeordnet ist. US 2008 / 260 187 A1 zeigt einen Lautsprecher, bei dem ein piezoelektrischer Wandler auf einer Innenseite eines topfförmigen Substrats angeordnet ist.

Aufgabe der vorliegenden Erfindung ist es nunmehr, eine verbesserte Vorrichtung anzugeben. Beispielsweise sollte die verbesserte Vorrichtung einen reduzierten Energieverbrauch oder eine reduzierte Anzahl von piezoelektrischen Elementen oder eine verringerte Ansteuerspannung ermöglichen.

Diese Aufgabe wird durch eine Vorrichtung gemäß Anspruch 1 gelöst. Der zweite unabhängige Anspruch löst die Aufgabe, ein Verfahren zur Herstellung einer derartigen verbesserten Vorrichtung anzugeben.

Es wird eine Vorrichtung vorgeschlagen, die einen Schwingkörper aufweist, auf dem ein piezoelektrisches Element durch eine Lotverbindung befestigt ist.

Im Vergleich zu einer Klebeverbindung weist die Lotverbindung eine höhere Steifigkeit auf. Schwingungen, die von dem piezoelektrischen Element erzeugt werden, können dadurch von der Lotverbindung besser an den Schwingkörper übertragen werden. Dabei dämpft die Lotverbindung die Schwingung kaum oder sogar gar nicht. Klebeverbindungen weisen ein viskoelastisches Verhalten auf, das eine von dem piezoelektrischen Element erzeugte Schwingung dämpft. Da die Lotverbindung kein viskoelastisches Verhalten aufweist, führt dieses bei der Lotverbindung nicht zu einer Dämpfung der Schwingung.

Darüber hinaus ermöglicht die Lotverbindung gegenüber einer Klebeverbindung eine verbesserte, zuverlässigere elektrische Kontaktierung des piezoelektrischen Elementes mit dem Schwingkörper. Wird für die Klebeverbindung ein organischer Klebstoff mit Zusätzen zur Erhöhung der elektrischen Leitfähigkeit verwendet, stellt dieses einen Kompromiss in der Haftfestigkeit dar, da die Zusätze keine Klebewirkung aufweisen und ihr Zusatz somit die Klebewirkung des Klebstoffes reduziert. Alternativ können sehr dünne Klebeschichten verwendet werden, die auch ohne derartige Zusätze eine elektrische Kontaktierung ermöglichen, die jedoch aufgrund der geringen Dicken auch eine schlechtere Klebewirkung zeigen.

Aufgrund der besseren mechanischen Verbindung des piezoelektrischen Elementes mit dem Schwingkörper bei Verwendung einer Lotverbindung kann im Vergleich zu einer Klebeverbindung bei gleichem Anregungssignal des piezoelektrischen Elementes der Schwingkörper zu einer Schwingung mit einer mehr als doppelt so großen Amplitude angeregt werden. Auf diese Weise ermöglicht es die Lotverbindung bei gleichem Anregungssignal, ein stärkeres haptisches Signal am Schwingkörper zu erzeugen. Dadurch kann es ermöglicht werden, Schwingkörper zu konstruieren, die eine geringere Anzahl an piezoelektrischen Elementen aufweisen oder die piezoelektrischen Elemente mit einem schwächeren Anregungssignal anzusteuern. Wird die Anzahl der piezoelektrischen Elemente reduziert, kann der Platzbedarf der Vorrichtung reduziert werden und neue Einsatzmöglichkeiten der Technik werden eröffnet. Durch die Verwendung eines schwächeren Anregungssignals kann der Energieverbrauch der Vorrichtung reduziert werden.

Das piezoelektrische Element kann eine monolithische piezoelektrische Schicht aufweisen. Die piezoelektrische Schicht kann zwischen zwei Elektroden angeordnet sein, die auf den Außenflächen des piezoelektrischen Elements angeordnet sind. Das piezoelektrische Element kann eine piezoelektrische Keramik, beispielsweise Blei-Zirkonat-Titanat-Keramik (PZT-Keramik) aufweisen. Alternativ kann das piezoelektrische Element ein piezoelektrisches Polymer aufweisen.

Alternativ kann das piezoelektrische Element ein Vielschichtelement sein, das übereinander gestapelte piezoelektrische Schichten und Innenelektroden aufweist. Die piezoelektrischen Schichten können eine piezoelektrische Keramik, beispielsweise eine PZT-Keramik, oder ein piezoelektrisches Polymer aufweisen.

Das piezoelektrische Element kann ein piezoelektrischer Aktuator sein. Der piezoelektrische Aktuator kann dazu ausgelegt sein, Schwingungen mit einer Frequenz im Ultraschallbereich zu erzeugen. Dabei können Schwingungen mit einer Frequenz zwischen 40 kHz und 120 kHz angeregt werden. Insbesondere können Frequenzen mit zwischen 60 und 80 kHz angeregt werden.

In einem weiteren Betriebsmodus kann das piezoelektrische Element als Sensor verwendet werden. Dabei kann das piezoelektrische Element dazu ausgestaltet sein, einen Druck zu erkennen, der auf ein mit dem Schwingkörper verbundenes Eingabeelement ausgeübt wird.

An dem Schwingkörper kann ein einziges piezoelektrisches Element oder mehrere piezoelektrische Elemente durch je eine Lotverbindung befestigt sein. Die Lotverbindungen können gleichzeitig in einem einzigen Lotprozess gefertigt werden. Der Schwingkörper kann eine Länge zwischen 50 mm und 300 mm aufweisen.

Der Schwingkörper kann ein leitfähiges Material aufweisen oder aus einem leitfähigen Material bestehen. Beispielsweise kann der Schwingkörper Aluminium oder rostfreien Stahl aufweisen. Rostfreier Stahl weist den Vorteil auf, dass dieser eine hohe Lotbarkeit aufweist und gut mit einer Lotverbindung verbunden werden kann. Aluminium weist die Vorteile eines vergleichsweise geringen Gewichtes und einer hohen Festigkeit auf.

Weist der Schwingkörper ein leitfähiges Material auf, kann der Schwingkörper über die Lotverbindung mit einer Elektrode des piezoelektrischen Elements verbunden sein. An die Elektrode kann über den Schwingkörper ein elektrisches Potential, beispielsweise ein Massepotential, angelegt werden.

Alternativ kann der Schwingkörper ein nichtleitendes Material aufweisen oder aus einem nichtleitenden Material bestehen. Beispielsweise kann der Schwingkörper ein Glas oder eine Keramik oder einen glasverstärkten Kunststoff aufweisen oder aus einem dieser Materialien bestehen. Zusätzlich können Leitungen auf einer dem piezoelektrischen Element zugewandten Seite des Schwingkörpers aufgebracht sein. Die Leitungen können beispielsweise in einem Beschichtungsverfahren aufgebracht werden.

Der Schwingkörper kann mit einer Beschichtung beschichtet sein, wobei die Lotverbindung auf der Beschichtung angeordnet sein kann. Die Beschichtung kann beispielsweise dazu dienen, die Benetzbarkeit des Schwingkörpers mit einem Lotmaterial zu verbessern. Die Beschichtung kann aufgesputtert sein. Die Beschichtung kann eine Chrom-aufweisende Schicht, eine Nickel-aufweisende Schicht und eine Silber-aufweisende Schicht aufweisen. Eine derartige Beschichtung ermöglicht es, die Benetzbarkeit eines Schwingkörpers aus Aluminium erheblich zu verbessern.

Das piezoelektrische Element kann eine Curietemperatur aufweisen, die höher ist als eine Schmelztemperatur eines Materials der Lotverbindung. Beispielsweise kann die Curietemperatur des piezoelektrischen Elementes größer als 300 °C sein. Dadurch kann vermieden werden, dass es während des Lötprozesses, bei dem das Material der Lotverbindung auf eine Temperatur erhitzt wird, die größer ist als eine Schmelztemperatur, zu einer Depolarisation des piezoelektrischen Elementes kommt. Beispielsweise kann der Lötprozess bei einer Temperatur zwischen 260 °C und 280 °C, beispielsweise bei 270 °C, durchgeführt werden. Alternativ ist es auch möglich, eine Polarisation des piezoelektrischen Elementes erst dann vorzunehmen, wenn der Lötprozess, bei dem das piezoelektrische Element an dem Schwingkörper befestigt wird, abgeschlossen ist.

Der Schwingkörper weist einen T-förmigen Querschnitt auf, der einen ersten Bereich mit einer ersten Breite und einen zweiten Bereich mit einer zweiten Breite aufweist, wobei die zweite Breite größer ist als die erste Breite und der erste Bereich mittig an dem zweiten Bereich angeordnet ist, wobei das piezoelektrische Element an einer Seite des zweiten Bereichs angeordnet ist, die vom ersten Bereich weg weist. Ein derartig geformter Schwingkörper kann es ermöglichen, von dem piezoelektrischen Element erzeugte Schwingungen an ein Eingabeelement, beispielsweise einen berührungsempfindlichen Bildschirm, weiterzugeben und dabei die Amplitude der Schwingung zu verstärken. Das piezoelektrische Element kann dazu ausgestaltet sein, den Schwingkörper zu einer Schwingung mit einer Frequenz im Ultraschallbereich anzuregen.

Die Lotverbindung kann ein bleifreies Lot aufweisen, beispielsweise ein SnAgCu-Lot.

Das piezoelektrische Element kann eine erste Elektrode und eine zweite Elektrode aufweisen. Auf dem Schwingkörper können zumindest zwei Leitungen angeordnet sein. Die erste Elektrode kann mit einer der zumindest zwei Leitungen durch die Lotverbindung verbunden sein. Die zweite Elektrode kann mit einer anderen der zumindest zwei Leitungen durch eine zweite Lotverbindung verbunden sein. Über die Leitungen kann dabei an die Elektroden ein Anregungssignal angelegt werden. Beispielsweise kann über die Leitungen eine Wechselspannung zwischen den Elektroden angelegt werden.

Die erste Elektrode kann auf der dem Schwingkörper zugewandten Seite des piezoelektrischen Elements angeordnet sein. Die zweite Elektrode kann auf der dem Schwingkörper abgewandten Seite des piezoelektrischen Elements angeordnet sein und sich über eine Seitenwand des piezoelektrischen Elements bis auf die dem Schwingkörper zugewandte Seite des piezoelektrischen Elements erstrecken. Beide Elektroden können über je eine Lotverbindung mit den Leitungen kontaktiert werden, wobei die beiden Lotverbindungen das gleiche Lotmaterial aufweisen können und in einem einzigen Lotprozess gefertigt werden können, beispielsweise einem einzigen Reflow-Lotprozess.

In einem alternativen Ausführungsbeispiel kann das piezoelektrische Element ebenfalls eine erste Elektrode und eine zweite Elektrode aufweisen, wobei die erste Elektrode auf einer dem Schwingkörper zugewandten Seite des piezoelektrischen Elements angeordnet ist und wobei die zweite Elektrode auf einer dem Schwingkörper abgewandten Seite des piezoelektrischen Elements angeordnet ist. In diesem Ausführungsbeispiel kann die erste Elektrode mit dem Schwingkörper durch die Lotverbindung verbunden sein und die zweite Elektrode kann über eine zweite Lotverbindung mit einem Anschlusselement verbunden sein. Das Anschlusselement kann eine Leitung sein, die beispielsweise mit einer flexiblen gedruckten Schaltung verbunden ist. Die Lotverbindung und die zweite Lotverbindung können das gleiche Lotmaterial aufweisen und in einem einzigen Lotprozess gefertigt werden, beispielsweise einem einzigen Reflow-Lotprozess.

Ein weiterer Aspekt der vorliegenden Erfindung betrifft ein Gerät, das die oben beschriebene Vorrichtung und ein Eingabeelement aufweist. Das Eingabeelement weist eine Oberseite und eine Unterseite auf, wobei der Schwingkörper an der Unterseite des Eingabeelementes befestigt ist. Insbesondere kann der Schwingkörper mit einer von dem piezoelektrischen Element weg weisenden Seite, beispielsweise dem ersten Bereich, an der Unterseite des Eingabeelementes befestigt sein. Bei dem Eingabeelement kann es sich um einen Bildschirm, vorzugsweise um einen berührungsempfindlichen Bildschirm, handeln.

Der Schwingkörper kann derart mit dem Eingabeelement verbunden sein, dass an dem Eingabeelement eine Schwingung mit einer Frequenz im Ultraschallbereich angeregt wird, wenn das piezoelektrische Element den Schwingkörper zu einer Schwingung anregt, wobei an der Oberseite des Eingabeelements eine stehende Welle erzeugt werden kann. Durch die Verwendung der Lotverbindung zwischen dem piezoelektrischen Element und dem Schwingkörper kann es ermöglicht werden, dass die von dem piezoelektrischen Element erzeugte Schwingung durch die Verbindung des piezoelektrischen Elementes mit dem Schwingkörper möglichst wenig gedämpft wird und so ein starkes Signal an das Eingabeelement übertragen werden kann. Insbesondere kann dadurch ein Signal erzeugt werden, das haptisch besser wahrnehmbar ist als ein Signal, das mit einer Vergleichsvorrichtung erzeugt wird, bei der das piezoelektrische Element mittels einer Klebeverbindung mit dem Schwingkörper verbunden ist.

Die stehende Welle kann zu einer Modulation einer Reibung an der Oberseite führen. Diese Modulation kann ein haptisch wahrnehmbares Signal darstellen.

Gemäß einem weiteren Aspekt betrifft die vorliegende Erfindung ein Verfahren zur Herstellung einer Vorrichtung, die einen Schwingkörper und ein piezoelektrisches Element aufweist, wobei das piezoelektrische Element mit dem Schwingkörper mittels einer Lotverbindung verbunden wird. Bei der Vorrichtung kann es sich um die oben beschriebene Vorrichtung handeln.

Die Lotverbindung kann in einem Reflow-Lötprozess oder einem Dampfphasen-Lötprozess oder durch eine Thermodenlötung erzeugt werden.

Das piezoelektrische Element kann vor oder nach dem Verbinden des piezoelektrischen Elementes mit dem Schwingkörper mittels der Lotverbindung polarisiert werden.

Es können zwei elektrische Verbindungen, die zum Anlegen einer Anregungsspannung an das piezoelektrische Element dienen, in einem einzigen Lötprozess gebildet werden. Bei den elektrischen Verbindungen kann es sich um die Lotverbindung und um eine zweite Lotverbindung handeln. Die Lotverbindung und die zweite Lotverbindung können mit dem gleichen Lotverfahren und dem gleichen Lotmaterial gleichzeitig gebildet werden.

Der Schwingkörper kann zumindest zwei Leitungen aufweisen, wobei eine erste Elektrode des piezoelektrischen Elements mit einer der zumindest zwei Leitungen durch die Lotverbindung kontaktiert ist, wobei eine zweite Elektrode des piezoelektrischen Elements mit einer weiteren der zumindest zwei Leitungen durch eine zweite Lotverbindung kontaktiert ist, und wobei die Lotverbindung und die zweite Lotverbindung in einem einzigen Lotprozess gebildet werden.

Im Folgenden werden bevorzugte Ausführungsbeispiele der Erfindung anhand der Figuren näher beschrieben.
Figur 1 zeigt eine Vorrichtung, die einen Schwingkörper und ein daran befestigtes piezoelektrisches Element aufweist.
Figur 2 zeigt eine Mikroskopaufnahme eines Teilbereichs der in Figur 1 gezeigten Vorrichtung.
Figur 3 zeigt ein Gerät, das die in Figur 1 gezeigte Vorrichtung aufweist.
Figur 4 zeigt ein erstes Ausführungsbeispiel der Vorrichtung in perspektivischer Ansicht.
Figur 5 zeigt das Ergebnis einer Vergleichsmessung.
Figur 6 zeigt eine Vorrichtung gemäß eines zweiten Ausführungsbeispiels.
Figur 7 zeigt ein drittes Ausführungsbeispiel der Vorrichtung.

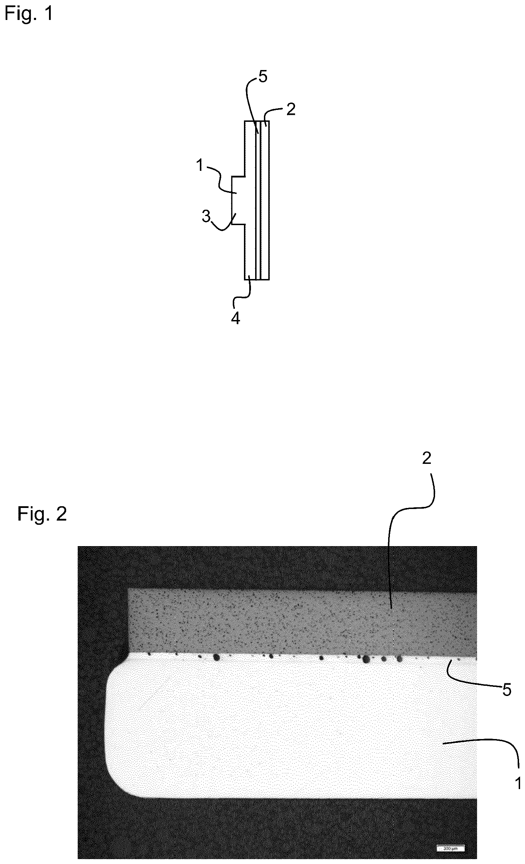

Figur 1 zeigt eine Vorrichtung, die einen Schwingkörper 1 und ein daran befestigtes piezoelektrisches Element 2 aufweist. Das piezoelektrische Element 2 ist ein piezoelektrischer Aktuator, der dazu ausgestaltet ist, den Schwingkörper 1 in eine Schwingung zu versetzen. An dem Schwingkörper 1 können mehrere piezoelektrische Elemente 2 befestigt sein.

Der Schwingkörper 1 weist einen T-förmigen Querschnitt auf. Der Schwingkörper weist einen ersten Bereich 3 auf, der im Querschnitt des Schwingkörpers 1 eine vertikale Linie der T-Form bildet. Ferner weist der Schwingkörper 1 einen zweiten Bereich 4 auf, der im Querschnitt eine horizontalte Linie der T-Form bildet. Das piezoelektrische Element 2 ist an einer Seite des zweiten Bereichs 4 befestigt, die von dem ersten Bereich 3 weg weist.

Das piezoelektrische Element 2 ist an dem Schwingkörper 1 durch eine Lotverbindung 5 befestigt. Die Lotverbindung 5 weist ein bleifreies Lotmaterial auf. Bei dem Lotmaterial kann es sich beispielsweise um SnAgCu-Lot handeln. Die Lotverbindung 5 sorgt neben der mechanischen Befestigung des piezoelektrischen Elementes 2 an dem Schwingkörper 1 auch für eine elektrische Kontaktierung des piezoelektrischen Elementes 2 mit dem Schwingkörper 1.

Das piezoelektrische Element 2 kann zu einer Schwingung mit einer Frequenz im Ultraschallbereich angeregt werden. Zu diesem Zweck kann eine Wechselspannung als Anregungssignal an das piezoelektrische Element 2 angelegt werden. Das Anregungssignal kann über den Schwingkörper 1 an das piezoelektrische Element 2 angelegt werden.

Das piezoelektrische Element 2 und der Schwingkörper 1 sind derart miteinander verbunden, dass die Schwingung des piezoelektrischen Elements 2 auf den Schwingkörper 1 übertragen wird und den Schwingkörper 1 zu einer Schwingung mit einer Frequenz im Ultraschallbereich anregt. Die Lotverbindung 5 weist eine hohe Steifigkeit auf und dämpft die Schwingung bei der Übertragung von dem piezoelektrischen Element 2 auf den Schwingkörper 1 nicht oder nur unwesentlich.

Das piezoelektrische Element 2 weist metallische Elektroden auf. Eine erste Elektrode 9 bedeckt die Fläche des piezoelektrischen Elements 2, die dem Schwingkörper 1 zugewandt ist. Eine zweite Elektrode 10 bedeckt die Fläche des piezoelektrischen Elements 2, die von dem Schwingkörper 1 abgewandt ist. Über die Lotverbindung 5 ist die erste Elektrode 9 an dem Schwingkörper 1 befestigt.

Die Elektroden 9, 10 können durch Dünnschichttechnik oder durch Dickschichttechnik erzeugt werden. Das piezoelektrische Element 2 kann beispielsweise zur Erzeugung der Elektroden 9, 10 mit einer Silberpaste in einem Dickschichtverfahren metallisiert werden.

Der Schwingkörper 1 kann ein leitfähiges Material aufweisen oder aus einem leitfähigen Material bestehen. Beispielsweise kann der Schwingkörper 1 Aluminium oder rostfreien Stahl aufweisen oder aus Aluminium oder rostfreiem Stahl bestehen. Aluminium weist eine unzureichende Lötbarkeit auf. Ein Schwingkörper 1, der Aluminium aufweist, kann daher zusätzlich eine Beschichtung aufweisen, die die Lötbarkeit verbessert. Die Beschichtung kann beispielsweise aufgesputtert werden. Die Beschichtung kann aus mehreren Teilschichten bestehen. Die Beschichtung kann eine Chrom-aufweisende Schicht, eine Nickel-aufweisende Schicht und eine Silber-aufweisende Schicht aufweisen.

Figur 2 zeigt eine Mikroskopaufnahme eines Teilbereichs der in Figur 1 gezeigten Vorrichtung. In Figur 2 sind das piezoelektrische Element 2, die Lotverbindung 5 und der Schwingkörper 1 gezeigt.

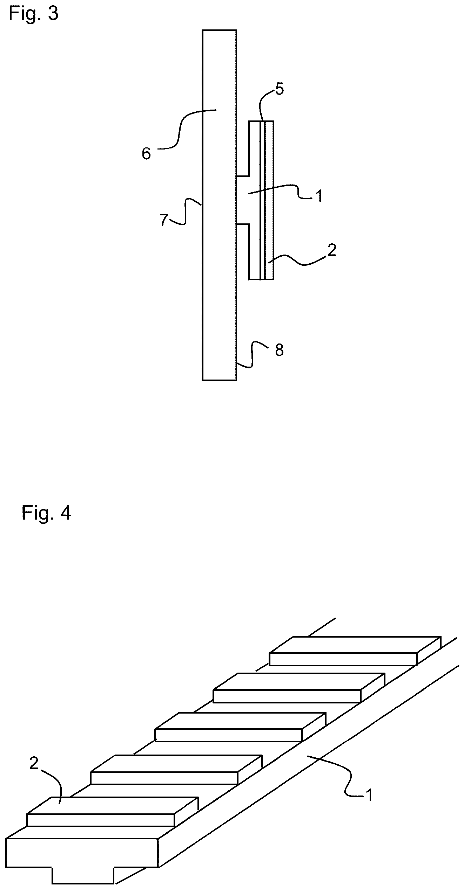

Figur 3 zeigt ein Gerät, das die in Figur 1 gezeigte Vorrichtung aufweist. Das Gerät weist zusätzlich ein Eingabeelement 6 auf. Das Eingabeelement 6 ist ein berührungsempfindlicher Bildschirm. Das Eingabeelement 6 weist eine Oberseite 7 auf, die von einem Nutzer beispielsweise mit seinem Finger oder einem Stift berührt werden kann, und eine Unterseite 8, die der Oberseite 7 gegenüberliegt und an der der Schwingkörper 1 befestigt ist, auf. Der erste Bereich 3 des Schwingkörpers 1 ist an der Unterseite 8 des Eingabeelementes 6 befestigt.

Der Schwingkörper 1 ist dazu ausgestaltet, die Schwingung an das Eingabeelement 6 zu übertragen, wenn der Schwingkörper 1 von dem piezoelektrischen Element 2 zu einer Schwingung mit einer Frequenz im Ultraschallbereich angeregt wird. Die auf das Eingabeelement 6 übertragene Schwingung erzeugt eine stehende Oberflächenwelle an der Oberseite 7 des Eingabeelementes 6. Ein Nutzer, der die Oberseite 7 des Eingabeelementes 6 berührt, spürt eine Modulation der Reibung, die von der stehenden Welle erzeugt wird. Diese Modulation der Reibung stellt ein für den Nutzer haptisch wahrnehmbares Signal dar. Insbesondere kann die stehende Welle eine Deformation der Oberseite 7 des Eingabeelements 6 mit einer Amplitude im Mikrometerbereich erzeugen, durch die Überdruckbereiche an der Oberseite 7 erzeugt werden. Die Überdruckbereiche führen zu einer Reduzierung des Reibungskoeffizienten, was von dem Nutzer haptisch wahrgenommen werden kann.

Figur 4 zeigt einen Teil eines ersten Ausführungsbeispiels der Vorrichtung in perspektivischer Ansicht.

Gemäß dem ersten Ausführungsbeispiel weist der Schwingkörper 1 einen Grundkörper mit T-förmigem Querschnitt auf, der aus Aluminium besteht. Der Schwingkörper 1 weist ferner eine Cr/Ni/Ag-Beschichtung auf, die auf dem Grundkörper mittels Sputtern aufgebracht wurden.

Der Schwingkörper gemäß dem ersten Ausführungsbeispiel weist eine Länge zwischen 150 mm und 200 mm auf. Als Länge des Schwingkörpers wird seine Ausdehnung in eine zu dem in Figur 1 gezeigten Querschnitt senkrechte Richtung bezeichnet.

An dem Schwingkörper 1 sind in dem ersten Ausführungsbeispiel 16 piezoelektrische Elemente 2 befestigt, die eine PZT-Keramik aufweisen, wobei Figur 4 nur einen Ausschnitt der Vorrichtung zeigt. In anderen Ausführungsbeispielen weist der Schwingkörper 1 eine andere Anzahl von piezoelektrischen Elementen 2 auf.

Die piezoelektrischen Elemente 2 wurden in dem ersten Ausführungsbeispiel jeweils durch eine Lotverbindung 5, die ein SnAgCu-Lot aufweist und die mittels Reflow-Löten gebildet wurde, mit dem Schwingkörper 1 verbunden.

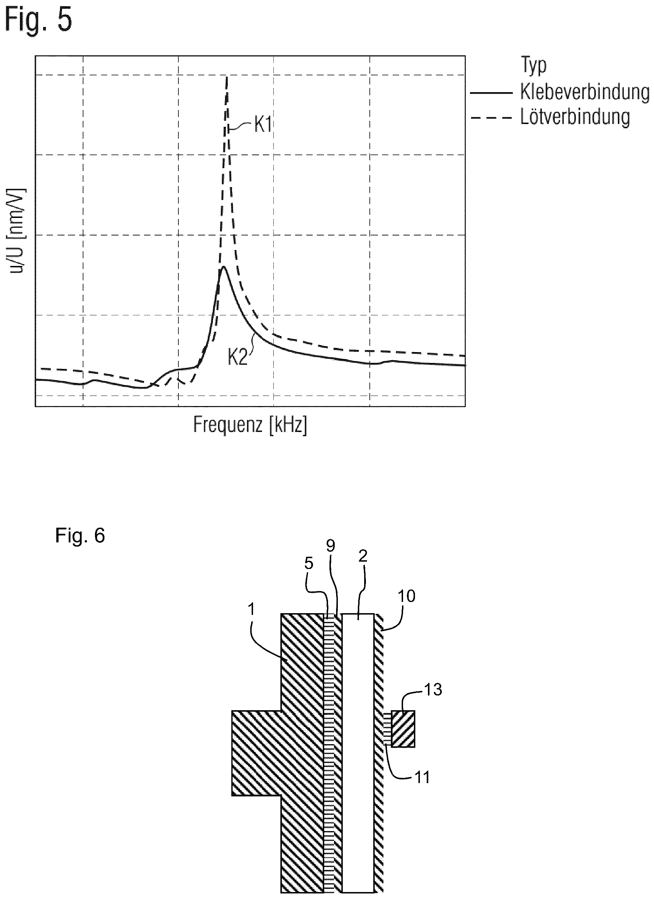

Figur 5 zeigt das Ergebnis einer Vergleichsmessung, bei der die Vorrichtung gemäß dem ersten Ausführungsbeispiel mit einer Referenzobjektes verglichen wurde.

Als Referenzobjekt wurde ein identischer Schwingkörper verwendet, an dem 16 identische piezoelektrische Elemente durch eine Klebeverbindung mit Acrylharz befestigt wurden.

An die piezoelektrischen Elemente 2 des ersten Ausführungsbeispiels und an die piezoelektrischen Elemente des Referenzobjekts wurde eine jeweils Wechselspannung angelegt. In beiden Fällen wurde dadurch eine Schwingung des jeweiligen Schwingkörpers 1 angeregt. Mit einem Laser-Doppler-Vibrometer wurde eine Amplitude der Schwingung des Schwingkörpers 1 gemessen. Bei der Messung wurde eine Frequenz der an die piezoelektrischen Elemente 2 angelegten Spannung verändert und es wurde jeweils die maximale Schwingamplitude an dem Schwingkörper 1 für die jeweilige Frequenz gemessen. Die Ergebnisse dieser Messung sind in Figur 5 aufgetragen, wobei auf der horizontalen Achse die Frequenz in beliebigen Einheiten aufgetragen ist und auf der vertikalen Achse die Auslenkung des Schwingkörpers 1 aufgetragen ist.

Die Kurve K1 zeigt die für das erste Ausführungsbeispiel ermittelten Messwerte. Die Kurve K2 zeigt die für das Referenzobjekt ermittelten Messwerte. Das Maximum der Kurve K1, die für das erste Ausführungsbeispiel ermittelt wurde, ist um mehr als das Doppelte höher als das Maximum der Kurve K2, die für das Referenzobjekt ermittelt wurde. Die Vergleichsmessung zeigt, dass durch die Verwendung einer Lotverbindung 5 zum Befestigen der piezoelektrischen Elemente 2 an dem Schwingkörper 1 gegenüber einer Klebeverbindung der piezoelektrischen Elemente 2 an dem Schwingkörper 1 bei identischem Anregungssignal eine Amplitude der Schwingung des Schwingkörpers 1 vergrößert wird. Es wurde eine Verbesserung der Amplitude um den Faktor 2,4 gemessen.

Diese Verbesserung der Schwingungsamplitude bei Verwendung einer Lotverbindung 5 ergibt sich daraus, dass die Lotverbindung 5 gegenüber der Klebeverbindung eine höhere Steifigkeit aufweist und dass die Lotverbindung 5 im Gegensatz zu der Klebeverbindung kein viskoelastisches Verhalten zeigt. Beide Eigenschaften führen dazu, dass die Lotverbindung 5 die von dem piezoelektrischen Element 2 erzeugte Schwingung weniger dämpft als eine Klebeverbindung. Ein weiterer Vorteil der Lotverbindung 5 gegenüber einer Klebeverbindung besteht darin, dass die Lotverbindung 5 eine bessere elektrische Kontaktierung des piezoelektrischen Elementes 2 mit dem Schwingkörper 1 ermöglicht als eine Klebeverbindung.

Die Lotverbindung 5 führt gegenüber einer Klebeverbindung zu einem Schwingverhalten des Schwingkörpers 1 mit einer höheren Schwingungsgüte. Daher ist der Peak der Kurve K1 höher als der Peak der Kurve K2 und daher weist der Peak der Kurve K1 steilere Flanken auf.

Figur 6 zeigt eine Vorrichtung gemäß eines zweiten Ausführungsbeispiels.

Gemäß dem zweiten Ausführungsbeispiel weisen die Schwingkörper 1 eine Länge zwischen 50 mm und 150 mm auf, beispielsweise 90 mm**.** Die Schwingkörper 1 weisen gemäß dem zweiten Ausführungsbeispiel rostfreien Stahl auf. Auf eine zusätzliche Beschichtung des Schwingkörpers 1 kann verzichtet werden, da rostfreier Stahl eine gute Lotbarkeit aufweist.

Gemäß dem zweiten Ausführungsbeispiel werden acht piezoelektrische Elemente 2, die eine PZT-Keramik aufweisen, mittels einer Lotverbindung 5 an dem Schwingkörper 1 befestigt. Insbesondere wird die erste Elektrode der piezoelektrischen Elemente 2 durch die Lotverbindung 5 mit dem Schwingkörper 1 verbunden. Über den Schwingköper 1 sind die ersten Elektroden 9 mit einer Spannungsquelle oder einer Erdung verbunden.

Die zweite Elektrode 10, die auf der vom Schwingkörper 1 abgewandten Seite des piezoelektrischen Elements 1 angeordnet ist, ist über eine zweite Lotverbindung 11 mit einem Anschlusselement 13 verbunden. Das Anschlusselement 13 ist dazu ausgestaltet, ein elektrisches Potential an die zweite Elektrode 10 anzulegen. Das Anschlusselement 13 kann eine Anschlussleitung sein, die mit einer flexibel gedruckten Schaltung verbunden ist.

Die Lotverbindung 5 und die zweite Lotverbindung 11 können in einem einzigen Prozessschritt gemeinsam gefertigt werden. Die Lotverbindung 5 und die zweite Lotverbindung 11 können mit dem gleichen Verfahren gebildet werden. Die Lotverbindung 5 und die zweite Lotverbindung 11 weisen jeweils ein bleifreies Lot, beispielsweise ein SnAgCu-Lot, auf und wurden mittels eines Reflow-Verfahrens gefertigt.

Das zweite Ausführungsbeispiel wurde mit einem weiteren Referenzobjekt verglichen. Der Schwingkörper des weiteren Referenzobjektes ist identisch zu dem Schwingkörper 1 des zweiten Ausführungsbeispiels. An dem Schwingkörper des weiteren Referenzobjektes wurden acht piezoelektrische Elemente befestigt, die mit den piezoelektrischen Elementen 2 des zweiten Ausführungsbeispiels baugleich sind. Für das weitere Referenzobjekt wurden die piezoelektrischen Elemente mittels Epoxidharz an den Schwingkörper geklebt. Der Vergleich des zweiten Ausführungsbeispiels mit dem weiteren Referenzobjekt zeigt ebenfalls, dass durch die Befestigung der piezoelektrischen Elemente 2 an dem Schwingkörper 1 eine Amplitude der Schwingung des Schwingkörpers 1 gegenüber einem Vergleichsobjekt, bei dem die piezoelektrischen Elemente an den Schwingkörper geklebt werden, vergrößert wird.

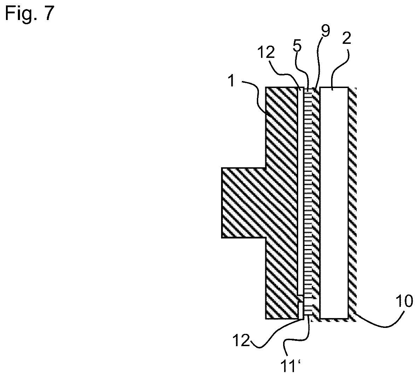

Figur 7 zeigt ein drittes Ausführungsbeispiel der Vorrichtung.

Gemäß dem dritten Ausführungsbeispiel weist der Schwingkörper 1 ein nicht-leitendes Material auf. Der Schwingkörper 1 kann ein Glas, eine Keramik oder einen glasverstärkten Kunststoff aufweisen oder aus einem dieser Materialien bestehen.

Auf dem Schwingkörper 1 sind zwei oder mehr elektrische Leitungen 12 durch Beschichtungsverfahren aufgebracht. Die erste Elektrode 9 und die zweite Elektrode 10 des piezoelektrischen Elements 2 sind so ausgeführt, dass sie gleichzeitig mit den Leitungen 12 auf dem Schwingkörper 1 verlötet werden können. Die erste Elektrode 9 ist dem Schwingkörper 1 zugewandt und wird durch die Lotverbindung 5 mit einer der Leitungen auf dem Schwingkörper 1 kontaktiert. Die zweite Elektrode 10 erstreckt sich von der dem Schwingkörper 1 abgewandten Seite des piezoelektrischen Elements 2 über eine Seitenwand des piezoelektrischen Elements 2 auf die dem Schwingkörper 1 zugewandte Seite des piezoelektrischen Elements 2. An der dem Schwingkörper 1 zugewandte Seite des piezoelektrischen Elements 2 ist die zweite Elektrode 10 mit einer anderen der Leitungen 12 auf dem Schwingkörpers 1 kontaktiert. Dabei ist die zweite Elektrode 10 mit dem Schwingkörper 1 durch eine zweite Lotverbindung 11' kontaktiert.

Die Lotverbindung 5 zwischen der ersten Elektrode 9 und einer der Leitungen 12 und die zweite Lotverbindung 11' zwischen der zweiten Elektrode 10 und einer anderen der Leitungen 12 werden gleichzeitig in einem einzigen Lötprozess gebildet.

### Bezugszeichenliste

- 1: Schwingkörper
- 2: piezoelektrisches Element
- 3: erster Bereich des Schwingkörpers
- 4: zweiter Bereich des Schwingkörpers
- 5: Lotverbindung
- 6: Eingabeelement
- 7: Oberseite des Eingabeelements
- 8: Unterseite des Eingabeelements
- 9: erste Elektrode des piezoelektrischen Elements
- 10: zweite Elektrode des piezoelektrischen Elements
- 11: zweite Lotverbindung
- 11': zweite Lotverbindung
- 12: Leitung
- 13: Anschlusselement

- K1: Kurve, die die für das erste Ausführungsbeispiel ermittelten Messwerte zeigt
- K2: Kurve, die die für das Referenzobjekt ermittelten Messwerte zeigt

## Patentansprüche

1. Vorrichtung, die einen Schwingkörper (1) aufweist, auf dem ein piezoelektrisches Element (2) durch eine Lotverbindung (5) befestigt ist,
wobei der Schwingkörper (1) einen T-förmigen Querschnitt aufweist, der einen ersten Bereich (3) mit einer ersten Breite und einen zweiten Bereich (4) mit einer zweiten Breite aufweist, wobei die zweite Breite größer ist als die erste Breite und der erste Bereich mittig an dem zweiten Bereich angeordnet ist,
wobei das piezoelektrische Element (2) an einer Seite des zweiten Bereichs angeordnet ist, die vom ersten Bereich weg weist.

2. Vorrichtung gemäß Anspruch 1,
wobei der Schwingkörper (1) ein leitfähiges Material, beispielsweise Aluminium oder rostfreien Stahl, aufweist, oder
wobei der Schwingkörper (1) ein nichtleitendes Material, beispielsweise ein Glas oder eine Keramik oder einen glasverstärkten Kunststoff, aufweist.

3. Vorrichtung gemäß einem der vorherigen Ansprüche,
wobei der Schwingkörper (1) mit einer Beschichtung beschichtet ist und die Lotverbindung (5) auf der Beschichtung angeordnet ist.

4. Vorrichtung gemäß einem der vorherigen Ansprüche,
wobei das piezoelektrische Element (2) eine Curietemperatur aufweist, die höher ist als eine Schmelztemperatur eines Materials der Lotverbindung (5).

5. Vorrichtung gemäß einem der vorherigen Ansprüche,
wobei das piezoelektrische Element (2) dazu ausgestaltet ist, den Schwingkörper (1) zu einer Schwingung mit einer Frequenz im Ultraschallbereich anzuregen.

6. Vorrichtung gemäß einem der vorherigen Ansprüche,
wobei die Lotverbindung (5) ein bleifreies Lot aufweist.

7. Vorrichtung gemäß einem der vorherigen Ansprüche,
wobei das piezoelektrische Element (2) eine erste Elektrode (9) und eine zweite Elektrode (10) aufweist,
wobei auf dem Schwingkörper (1) zumindest zwei Leitungen (12) angeordnet sind,
wobei die erste Elektrode (9) mit einer der zumindest zwei Leitungen (12) durch die Lotverbindung (5) verbunden ist, und
wobei die zweite Elektrode (10) mit einer anderen der zumindest zwei Leitungen (12) durch eine zweite Lotverbindung (11') verbunden ist.

8. Vorrichtung gemäß einem der Ansprüche 1 bis 6,
wobei das piezoelektrische Element (2) eine erste Elektrode (9) und eine zweite Elektrode (10) aufweist,
wobei die erste Elektrode (9) auf einer dem Schwingkörper (1) zugewandten Seite des piezoelektrischen Elements (2) angeordnet ist, wobei die zweite Elektrode (10) auf einer dem Schwingkörper (1) abgewandten Seite des piezoelektrischen Elements (2) angeordnet ist,
wobei die erste Elektrode (9) mit dem Schwingkörper (1) durch die Lotverbindung (5) verbunden ist, und
wobei die zweite Elektrode (10) über eine zweite Lotverbindung (11) mit einem Anschlusselement (13) verbunden ist.

9. Gerät aufweisend eine Vorrichtung gemäß einem der vorherigen Ansprüche und eine Eingabeelement,
wobei das Eingabeelement eine Oberseite und eine Unterseite aufweist, und
wobei der Schwingkörper (1) an der Unterseite des Eingabeelements befestigt ist.

10. Gerät gemäß dem vorherigen Anspruch,
wobei das Eingabeelement (6) ein berührungsempfindlicher Bildschirm ist.

11. Gerät gemäß Anspruch 9 oder Anspruch 10,
wobei der Schwingkörper (1) derart mit dem Eingabeelement (6) verbunden ist, dass an dem Eingabeelement (6) ein Schwingung mit einer Frequenz im Ultraschallbereich angeregt wird, wenn das piezoelektrische Element (2) den Schwingkörper (1) zu einer Schwingung anregt, wobei an der Oberseite des Eingabeelements eine stehende Welle erzeugt wird.

12. Verfahren zur Herstellung einer Vorrichtung, die einen Schwingkörper (1) und ein piezoelektrisches Element (2) aufweist, aufweisend den Schritt:
- Verbinden des piezoelektrischen Elements (2) mit dem Schwingkörper (1) mittels einer Lotverbindung (5), wobei der Schwingkörper (1) einen T-förmigen Querschnitt aufweist, der einen ersten Bereich (3) mit einer ersten Breite und einen zweiten Bereich (4) mit einer zweiten Breite aufweist, wobei die zweite Breite größer ist als die erste Breite und der erste Bereich mittig an dem zweiten Bereich angeordnet ist,
wobei das piezoelektrische Element (2) an einer Seite des zweiten Bereichs angeordnet ist, die vom ersten Bereich weg weist.

13. Verfahren gemäß dem vorherigen Anspruch,
wobei die Lotverbindung (5) in einem Reflow-Lötprozess oder einem Dampfphasen-Lötprozess oder durch eine Thermodenlötung erzeugt wird.

14. Verfahren gemäß einem der Ansprüche 12 oder 13,
wobei das piezoelektrische Element (2) vor dem Verbinden des piezoelektrischen Elements (2) mit dem Schwingkörper (1) mittels der Lotverbindung (5) polarisiert wird,
oder
wobei das piezoelektrische Element (2) nach dem Verbinden des piezoelektrischen Elements (2) mit dem Schwingkörper (1) mittels der Lotverbindung (5) polarisiert wird.

15. Verfahren gemäß einem der Ansprüche 12 bis 14,
wobei die Lotverbindung (5) und eine zweite Lotverbindung (11, 11`) in einem einzigen Lötprozess gebildet werden,
wobei die Lotverbindung (5) und die zweite Lotverbindung (11, 11') dazu ausgestaltet sind, eine Anregungsspannung an das piezoelektrische Element (2) anzulegen.

16. Verfahren gemäß einem der Ansprüche 12 bis 14,
wobei der Schwingkörper (1) zumindest zwei Leitungen aufweist, wobei eine erste Elektrode (9) des piezoelektrischen Elements (2) mit einer der zumindest zwei Leitungen durch die Lotverbindung (5) kontaktiert ist,
wobei eine zweite Elektrode (10) des piezoelektrischen Elements (2) mit einer weiteren der zumindest zwei Leitungen durch eine zweite Lotverbindung (11') kontaktiert ist, und
wobei die Lotverbindung (5) und die zweite Lotverbindung (11') in einem einzigen Lotprozess gebildet werden.

## Claims

1. Apparatus having a oscillating body (1) on which a piezoelectric element (2) is fastened by a solder connection (5),
wherein the oscillating body (1) has a T-shaped cross section having a first region (3) with a first width and a second region (4) with a second width, the second width being greater than the first width and the first region being arranged in the centre of the second region,
wherein the piezoelectric element (2) is arranged on a side of the second region facing away from the first region.

2. Apparatus according to Claim 1,
wherein the oscillating body (1) has a conductive material, for example aluminium or stainless steel, or
wherein the oscillating body (1) has a non-conductive material, for example a glass or a ceramic or a glass-reinforced plastic.

3. Apparatus according to one of the preceding claims, wherein the oscillating body (1) is coated with a coating and the solder connection (5) is arranged on the coating.

4. Apparatus according to one of the preceding claims, wherein the piezoelectric element (2) has a Curie temperature which is higher than a melting temperature of a material of the solder connection (5).

5. Apparatus according to one of the preceding claims, wherein the piezoelectric element (2) is configured to excite the oscillating body (1) to oscillate at a frequency in the ultrasonic range.

6. Apparatus according to one of the preceding claims, wherein the solder connection (5) comprises a lead-free solder.

7. Apparatus according to one of the preceding claims,
wherein the piezoelectric element (2) has a first electrode (9) and a second electrode (10), wherein at least two lines (12) are arranged on the oscillating body (1),
wherein the first electrode (9) is connected to one of the at least two lines (12) by means of the solder connection (5), and
wherein the second electrode (10) is connected to another of the at least two lines (12) by means of a second solder connection (11').

8. Apparatus according to one of Claims 1 to 6,
wherein the piezoelectric element (2) has a first electrode (9) and a second electrode (10),
wherein the first electrode (9) is arranged on a side of the piezoelectric element (2) facing the oscillating body (1), wherein the second electrode (10) is arranged on a side of the piezoelectric element (2) facing away from the oscillating body (1),
wherein the first electrode (9) is connected to the oscillating body (1) by the solder connection (5), and wherein the second electrode (10) is connected to a connecting element (13) via a second solder connection (11).

9. Device having an apparatus according to one of the preceding claims and an input element,
wherein the input element has a top side and an underside, and
wherein the oscillating body (1) is fastened to the underside of the input element.

10. Device according to the preceding claim,
wherein the input element (6) is a touch-sensitive screen.

11. Device according to Claim 9 or Claim 10,
wherein the oscillating body (1) is connected to the input element (6) in such a way that an oscillation at a frequency in the ultrasonic range is excited at the input element (6) when the piezoelectric element (2) excites the oscillating body (1) to oscillate, wherein a standing wave is generated on the top side of the input element.

12. Method for producing an apparatus having an oscillating body (1) and a piezoelectric element (2), having the step of:
- connecting the piezoelectric element (2) to the oscillating body (1) by means of a solder connection (5), wherein the oscillating body (1) has a T-shaped cross section having a first region (3) with a first width and a second region (4) with a second width, the second width being greater than the first width and the first region being arranged in the centre of the second region,
wherein the piezoelectric element (2) is arranged on a side of the second region facing away from the first region.

13. Method according to the preceding claim,
wherein the solder connection (5) is produced in a reflow soldering process or a vapour phase soldering process or by thermode soldering.

14. Method according to either of Claims 12 and 13,
wherein the piezoelectric element (2) is polarized by means of the solder connection (5) before connecting the piezoelectric element (2) to the oscillating body (1), or
wherein the piezoelectric element (2) is polarized by means of the solder connection (5) after connecting the piezoelectric element (2) to the oscillating body (1).

15. Method according to one of Claims 12 to 14,
wherein the solder connection (5) and a second solder connection (11, 11') are formed in a single soldering process,
wherein the solder connection (5) and the second solder connection (11, 11') are configured to apply an excitation voltage to the piezoelectric element (2).

16. Method according to one of Claims 12 to 14,
wherein the oscillating body (1) has at least two lines,
wherein a first electrode (9) of the piezoelectric element (2) makes contact with one of the at least two lines through the solder connection (5),
wherein a second electrode (10) of the piezoelectric element (2) makes contact with a further one of the at least two lines through a second solder connection (11'), and
wherein the solder connection (5) and the second solder connection (11') are formed in a single soldering process.

## Revendications

1. Dispositif comprenant un corps oscillant (1) sur lequel un élément piézoélectrique (2) est fixé par une liaison par soudure (5),
le corps oscillant (1) présentant une section transversale en forme de T, qui comprend une première zone (3) d'une première largeur et une deuxième zone (4) d'une deuxième largeur, la deuxième largeur étant supérieure à la première largeur et la première zone étant agencée au centre de la deuxième zone,
l'élément piézoélectrique (2) étant agencé sur un côté de la deuxième zone, qui est opposé à la première zone.

2. Dispositif selon la revendication 1,
dans lequel le corps oscillant (1) est constitué d'un matériau conducteur, par exemple de l'aluminium ou de l'acier inoxydable, ou
dans lequel le corps oscillant (1) est constitué d'un matériau non conducteur, par exemple du verre, de la céramique ou un plastique renforcé de verre.

3. Dispositif selon l'une des revendications précédentes,
dans lequel le corps oscillant (1) est recouvert d'un revêtement et la liaison par soudure (5) est agencée sur le revêtement.

4. Dispositif selon l'une des revendications précédentes,
dans lequel l'élément piézoélectrique (2) a une température de Curie supérieure à la température de fusion d'un matériau de la liaison par soudure (5).

5. Dispositif selon l'une des revendications précédentes,
dans lequel l'élément piézoélectrique (2) est conçu pour exciter le corps oscillant (1) à une fréquence située dans la gamme des ultrasons.

6. Dispositif selon l'une des revendications précédentes,
dans lequel la liaison par soudure (5) comprend une soudure sans plomb.

7. Dispositif selon l'une des revendications précédentes,
dans lequel l'élément piézoélectrique (2) comprend une première électrode (9) et une deuxième électrode (10), au moins deux lignes conductrices (12) étant agencées sur le corps oscillant (1),
la première électrode (9) étant reliée à l'une des au moins deux lignes (12) par la liaison par soudure (5), et
la deuxième électrode (10) étant reliée à une autre des au moins deux lignes conductrices (12) par une deuxième liaison par soudure (11').

8. Dispositif selon l'une des revendications 1 à 6,
dans lequel l'élément piézoélectrique (2) présente une première électrode (9) et une deuxième électrode (10),
la première électrode (9) étant agencée sur un côté de l'élément piézoélectrique (2) tourné vers le corps oscillant (1), la deuxième électrode (10) étant agencée sur un côté de l'élément piézoélectrique (2) opposé au corps oscillant (1),
la première électrode (9) étant reliée au corps oscillant (1) par la liaison par soudure (5), et
la deuxième électrode (10) étant reliée à un élément de raccordement (13) par une deuxième liaison par soudure (11).

9. Appareil comprenant un dispositif selon l'une des revendications précédentes et un élément d'entrée,
dans lequel l'élément d'entrée présente une face supérieure et une face inférieure, et
dans lequel le corps oscillant (1) est fixé sur la face inférieure de l'élément d'entrée.

10. Appareil selon la revendication précédente,
dans lequel l'élément d'entrée (6) est un écran tactile.

11. Appareil selon la revendication 9 ou la revendication 10,
dans lequel le corps oscillant (1) est relié à l'élément d'entrée (6) de telle sorte qu'une oscillation d'une fréquence située dans la gamme des ultrasons est excitée sur l'élément d'entrée (6) lorsque l'élément piézoélectrique (2) excite le corps oscillant (1) de sorte qu'il oscille, une onde stationnaire étant générée sur la face supérieure de l'élément d'entrée.

12. Procédé de fabrication d'un dispositif comprenant un corps oscillant (1) et un élément piézoélectrique (2), comprenant l'étape consistant à :
- relier l'élément piézoélectrique (2) au corps oscillant (1) au moyen d'une liaison par soudure (5),
le corps oscillant (1) présentant une section transversale en forme de T, qui comprend une première zone (3) d'une première largeur et une deuxième zone (4) d'une deuxième largeur, la deuxième largeur étant supérieure à la première largeur et la première zone étant agencée au centre de la deuxième zone,
l'élément piézoélectrique (2) étant agencé sur un côté de la deuxième zone, qui est opposé à la première zone.

13. Procédé selon la revendication précédente,
dans lequel la liaison par soudure (5) est réalisée par un procédé de soudure par refusion ou un procédé de soudure en phase vapeur ou par une soudure thermique.

14. Procédé selon l'une des revendications 12 ou 13,
dans lequel l'élément piézoélectrique (2) est polarisé au moyen de la liaison par soudure (5) avant que l'élément piézoélectrique (2) soit relié à l'élément oscillant (1), ou
dans lequel l'élément piézoélectrique (2) est polarisé au moyen de la liaison par soudure (5) après que l'élément piézoélectrique (2) a été relié à l'élément oscillant (1).

15. Procédé selon l'une des revendications 12 à 14,
dans lequel la liaison par soudure (5) et une deuxième liaison par soudure (11, 11') sont formées en une seule opération de soudage,
la liaison par soudure (5) et la deuxième liaison par soudure (11, 11') étant conçues de façon à appliquer une tension d'excitation à l'élément piézoélectrique (2).

16. Procédé selon l'une des revendications 12 à 14,
dans lequel le corps oscillant (1) présente au moins deux conducteurs, une première électrode (9) de l'élément piézoélectrique (2) étant mise en contact avec l'une des au moins deux lignes conductrices par la liaison par soudure (5),
une deuxième électrode (10) de l'élément piézoélectrique (2) étant mise en contact avec une autre des au moins deux lignes conductrices par une deuxième liaison par soudure (11'), et
la liaison par soudure (5) et la deuxième liaison par soudure (11') étant formées au cours d'un seul processus de soudage.
